# EUROPÄISCHE PATENTSCHRIFT

(11) **EP 0 993 054 B1**
(45) Veröffentlichungstag und Bekanntmachung des Hinweises auf die Patenterteilung: **09.05.2007**
(21) Anmeldenummer: 99118468.0
(22) Anmeldetag: 17.09.1999
(51) Int. Cl.: H01L 43/08, H01F 10/32

(54) **Dünnschichtenaufbau eines magnetfeldempfindlichen Sensors mit einem magnetoresistiven Mehrschichtensystem mit Spinabhängigkeit der Elektronenstreuung**
Thin film magnetic field sensor structure having magneto-resistive multilayer system with spin dependent electron scattering
Capteur magnétique à couche mince comportant un système multicouche magnetorésistif avec diffusion d'électrons dépendante du spin magnétique

(30) Priorität: 30.09.1998 DE 19844890
(43) Veröffentlichungstag der Anmeldung: 12.04.2000
(73) Patentinhaber: Infineon Technologies AG, 81669 München (DE)
(72) Erfinder: van den Berg, Hugo, Dr., 91074 Herzogenaurach (DE); Persat, Nathalie, 5655 HS Eindhoven (DE)
(74) Vertreter: Zimmermann & Partner

(56) Entgegenhaltungen:
- DE-A1- 19 652 536
- BLAND J A C ET AL: "Exchange-coupled MBE-grown Co/Cu/Co(111) trilayers" JOURNAL OF MAGNETISM AND MAGNETIC MATERIALS, ELSEVIER SCIENCE PUBLISHERS, AMSTERDAM, NL, Bd. 154, Nr. 3, Mai 1996 (1996-05), Seiten 301-320, XP004078561 ISSN: 0304-8853

## Beschreibung

Die Erfindung bezieht sich auf einen Dünnschichtenaufbau eines magnetfeldempfindlichen Sensors mit einem Mehrschichtensystem, das einen erhöhten magnetoresistiven Effekt sowie eine Spinabhängigkeit der Elektronenstreuung von Majoritäts- und Minoritätselektronen zeigt und das mindestens eine die Elektronen in Abhängigkeit von ihrem Spin reflektierende Grenzfläche zwischen benachbarten Schichten sowie Bereiche enthält, in denen eine zumindest weitgehend diffuse Streuung von nicht-reflektierten Elektronen erfolgt. Ein entsprechender Dünnschichtenaufbau geht aus der *DE 196 52 536 A1* hervor.

In Schichten aus ferromagnetischen Übergangsmetallen wie Ni, Fe, Co und deren Legierungen kann eine Abhängigkeit des elektrischen Widerstandes von der Größe eines in das Material eindringenden Magnetfeldes gegeben sein. Den bei solchen Schichten auftretenden Effekt nennt anisotropen Magnetowiderstand "AMR" oder anisotropen magnetoresistiven Effekt. Er beruht physikalisch auf unterschiedlichen Streuquerschnitten von Elektronen mit unterschiedlichem Spin und der Spinpolarität des d-Bandes. Die Elektronen werden deshalb als Majoritäts- bzw. Minoritäts(leitungs)elektronen bezeichnet. Für entsprechende magnetoresistive Sensoren wird im allgemeinen eine dünne Schicht aus einem solchen magnetoresistiven Material mit einer Magnetisierung in der Schichtebene vorgesehen. Die Widerstandsänderung bei Drehung der Magnetisierung bezüglich der Richtung eines in der Ebene fließenden Stromes kann dann einige Prozent des normalen isotropen (= ohmschen) Widerstandes betragen.

Ferner sind seit einiger Zeit magnetoresistive Mehrschichtensysteme bekannt, welche mehrere, zu einem Stapel angeordnete ferromagnetische Schichten enthalten, die jeweils durch metallische Zwischenschichten voneinander getrennt sind und deren Magnetisierungen jeweils in der Schichtebene liegen. Die Dicken der einzelnen Schichten sind dabei deutlich geringer als die mittlere freie Weglänge der Leitungselektronen gewählt. In solchen in Dünnfilmtechnik zu erstellenden Mehrschichtensystemen kann nun zusätzlich zu dem erwähnten anisotropen magnetoresistiven Effekt AMR ein sogenannter giantmagnetoresistiver Effekt oder Giant-Magnetowiderstand "GMR" auftreten (vgl. *EP 0 483 373 A1*). Bisher wurde davon ausgegangen, daß ein solcher GMR-Effekt auf der unterschiedlich starken Streuung der Majoritäts- und Minoritätselektronen an Grenzflächen zwischen den ferromagnetischen Schichten und den dazu benachbarten Zwischenschichten sowie auf Streueffekten innerhalb dieser Schichten, insbesondere wenn diese Schichten aus Legierungen bestehen, beruht. Der GMR-Effekt ist dabei ein isotroper Effekt. Er kann erheblich größer sein als der anisotrope Effekt AMR und Werte beispielsweise bis 70 % des normalen isotropen Widerstandes annehmen. Im allgemeinen werden Magnetowiderstände mit Werten, die größer als 3 % des normalen isotropen Widerstandes betragen, als Giant-Magnetowiderstände bezeichnet.

In einen GMR-Effekt zeigenden, nachfolgend allgemein als "Mehrschichtensysteme mit erhöhtem magnetoresistiven Effekt" bezeichneten Schichtstapeln sind einander zugeordnete magnetische Schichten zunächst entgegengesetzt magnetisiert, wobei bei speziellen Ausführungsformen eine sogenannte Biasschicht bzw. ein Biasschichtsystem magnetisch härter als eine weichmagnetische Meßschicht ist. Unter Einfluß eines äußeren Magnetfeldes, d.h. einer in der Schichtebene ausgeprägten Komponente dieses Feldes, kann sich dann die anfänglich antiparallele Ausrichtung der Magnetisierungen in eine parallele umwandeln. Bei entsprechenden Magnetfeldsensoren wird diese Tatsache ausgenutzt.

Bei einem entsprechenden, aus der *WO94*/*15223 A1* entnehmbaren Dünnschichtenaufbau weist dessen einen erhöhten magnetoresistiven Effekt zeigendes Mehrschichtensystem ein magnetisches Biasschichtsystem mit einer Schichtenfolge auf, die einen sogenannten künstlichen Antiferromagneten bildet. Hierzu enthält das Biasschichtsystem eine Biasschicht, an welche über eine Kopplungsschicht antiferromagnetisch eine weitere Magnetschicht angekoppelt ist. Damit läßt sich verhindern, daß sich ein Teil des Magnetflusses der Biasschicht über die Meßschicht schließt. Ein entsprechender künstlicher Antiferromagnet ist somit nach außen hin magnetisch weitgehend neutral; d.h., sein Magnetfeld schließt sich praktisch ganz zwischen der Biasschicht und der zusätzlichen Magnetschicht. Damit ergibt sich der Vorteil einer Stabilisierung der Magnetisierung der Biasschicht auch bei starken äußeren Magnetfeldern.

Zur Erhöhung der Signalstärke von Mehrschichtensystemen mit erhöhtem magnetoresistiven Effekt ist es ferner bekannt, eine sich periodisch wiederholende Schichtenfolge vorzusehen (vgl. z.B. *DE 42 32 244 A1*). Denn die Signalstärke steigt mit der Anzahl der Perioden an gleichen Schichtpaketen asymptotisch bis zu einem Maximalwert monoton an. Die Anzahl der Perioden in einem entsprechenden Dünnschichtenaufbau kann ohne weiteres 100 oder mehr betragen. Der Aufwand zur Herstellung eines derartigen Aufbaus ist jedoch erheblich.

Ferner ist es aus der eingangs genannten DE 196 52 536 A1 bekannt, an wenigstens einer Seite eines magnetoresistiven Mehrschichtensystems mit vorzugsweise erhöhtem magnetoresistiven Effekt einen Reflektor oder Reflektorschichtteil anzuordnen, der bezüglich der Elektronen spinabhängig reflektierend ist. Hierzu soll dieser Reflektor mindestens eine die Elektronen in Abhängigkeit von ihrem Spin reflektierende Grenzfläche sowie Bereiche enthalten, in denen eine zumindest weitgehend diffuse Streuung von nicht-reflektierten Elektronen erfolgt. Der Reflektor kann dabei aus einer einzigen oder auch aus mehreren Schichten ausgebildet sein. Zu einer Reflexion von Minoritätselektronen kann für den spinabhängig reflektierenden Reflektor zumindest als Hauptbestandteil ein Material aus einem nicht-ferromagnetischen Element aus einer Gruppe des Periodensystems der Elemente gewählt werden, die eine - soweit vorhanden - im Periodensystem rechts von der Gruppe des ferromagnetischen Materials der benachbarten Schicht des Mehrschichtensystems liegende Gruppe VIIIb der Übergangsmetalle oder eine der Gruppen Ib, IIb oder IIIa ist. Als Materialien kommen deshalb z.B. die Elemente Cu, Ag, Au oder Al in Frage. Sollen hingegen nur Majoritätselektronen spinabhängig reflektiert werden, so ist zumindest als Hauptbestandteil des Reflektors ein Material aus einem nicht-ferromagnetischen Element aus einer Gruppe des Periodensystems der Elemente zu wählen, die eine im Periodensystem links von der Gruppe des ferromagnetischen Materials der benachbarten Schicht des Mehrschichtensystems liegende Gruppe IV bis VIII der Übergangsmetalle ist. Beispiele wären Mn, Cr, V oder Ti. Für den Reflektor kommen aber auch Halbmetalle, Materialien mit Perowskit-Kristallstruktur oder eine Heuslersche Mn-Al-Legierung in Frage.

Der Vorteil einer derartigen spinpolarisationsabhängigen Reflexion ist, daß auch mit verhältnismäßig wenigen Schichten ein hoher GMR-Signalpegel zu erreichen ist. Damit braucht man z.B. keine Sputtermodule mit rotierender Palette in eine Produktionskette aufzunehmen, wo sonst die Verweilzeit verhältnismäßig lang wäre. Die Abscheidungszeit wird also entsprechend verkürzt bei gleichzeitiger Kostensenkung. Da ferner die Gesamtdicke eines solchen Mehrschichtensystems kleiner gehalten werden kann, spielen entmagnetisierende Effekte nur eine untergeordnete Rolle. Diese Tatsache führt auch zu einer größeren Isotropie bei Winkeldetektoren, einer höheren Empfindlichkeit bei Feldsensoren und einer steileren Flanke bei Schwellwertdetektoren mit entsprechenden Mehrschichtensystemen.

Ferner ist es auch bekannt, auf die Außenflächen eines dreilagigen GMR-Magnetschichtsystems mit zwei magnetischen Schichten und einer dazwischenliegenden nicht-magnetischen Schicht jeweils eine perfekt reflektierende Schicht aufzubringen, um die Signalstärke zu erhöhen (vgl. *"Phys. Rev. B*" *Vol. 42, No. 13, 1 . Nov. 1990, Seiten 8110 bis 8120*).

Die DE 196 52 536 beschreibt einen Dünnschichtenaufbau eines magnetempfindlichen Sensors mit einem magnetoresistiven Magnetschichtsystem. Dafür wird ein Co/Cu-Schichtsystem vorgeschlagen.

Der Artikel *"Exchange-coupled MBD-grown ColCulCo(111) trilayers"* von Ives et al., Journal of Magnetism and Magnetic Materials, Elsevier Science Publishers, Amsterdam, NL, Bd. 154, Nr. 3, Mai 1996, Seiten 301-320, beschreibt das magnetische Verhalten eines Co/Cu/Co-Schichtsystems.

Aufgabe der vorliegenden Erfindung ist es, den Dünnschichtenaufbau mit den eingangs genannten Merkmalen dahingehend auszugestalten, daß eine weitere Erhöhung der Signalstärke bei gleichzeitig geringer Anzahl von Dünnschichten zu gewährleisten ist.

Außerdem ist mit der fehlenden Notwendigkeit von Schichtenwiederholungen eine Freiheit bei der Wahl der Materialien verbunden.

Diese Aufgabe wird erfindungsgemäß dadurch gelöst, daß die mindestens eine spinabhängig reflektierende Grenzfläche zwischen benachbarten Schichten liegt, deren Materialien
- aneinander angepaßte Gitterabmessungen mit Abweichungen von höchstens 3 % aufweisen
   und
- unter den Herstellungsbedingungen dieser Schichten nicht-mischbar sind.

Bei den erfindungsgemäßen Maßnahmen wird von der Erkenntnis ausgegangen, daß für die Höhe der Signalstärke eines GMR-Mehrschichtensystems nicht - wie bisher angenommen wurde - die spinabhängige Elektronenstreuung, sondern die spinabhängige Reflexion an Grenzflächen den entscheidenden Effekt darstellt. Mit den erfindungsgemäßen Maßnahmen ist nun eine besondere Auswahl an Materialkombinationen getroffen, bei denen Reflexions- und Streueffekte zugleich berücksichtigt werden. Auf diese Weise läßt sich vorteilhaft eine hohe Signalstärke erreichen.

Die vorzugsweise nach einer MBE-Technik zu erstellenden Schichten eines Mehrschichtensystems des erfindungsgemäßen Dünnschichtenaufbaus sind insbesondere im Fall der Zwischenschicht extrem dünn und liegen im allgemeinen in der Größenordnung von Nanometern. Bei derartig geringen Schichtdicken der Zwischenschicht besteht dann die Gefahr, daß unzusammenhängende, quasi inselartige Teilbereiche aus dem nicht-magnetischen Material entstehen. Es wurde nun erkannt, daß die auch als Plateaugröße zu bezeichnende Ausdehnung jedes dieser Bereiche in der Schichtebene eine bestimmte Mindestgröße haben muß, um die gewünschte Reflexionswirkung der diesbezüglichen Grenzfläche zu ermöglichen. Vorteilhaft ist deshalb die Zwischenschicht zumindest in Form von inselartigen Teilbereichen aus dem nicht-magnetischen Material ausgebildet, wobei die Teilbereiche jeweils eine Mindestfläche einnehmen, die einer kreisförmigen Fläche mit einem Durchmesser entspricht, der mindestens das 3-Fache der Atomabstände des nicht-magnetischen Materials der Zwischenschicht oder des magnetischen Materials der jeweils benachbarten magnetischen Schicht beträgt. Als Basis für die Größe dieser Mindestfläche wird dabei der jeweils kleinere Atomabstand des nicht-magnetischen und des magnetischen Materials genommen.

Ferner ist es als besonders vorteilhaft anzusehen, wenn zumindest eine der magnetischen Schichten einen der Zwischenschicht zugewandten schichtartigen Bereich mit spinselektiven Reflexionseigenschaften und einen demgegenüber weiter außenliegenden schichtartigen Bereich mit Streueigenschaften aufweist. Bei einer entsprechenden Ausgestaltung erfolgt die spinselektive Reflexion nicht nur an der Grenzfläche zwischen dem Zwischenschichtmaterial und dem angrenzenden magnetischen Material, sondern auch in dem angrenzenden Bereich der magnetischen Schicht mit spinselektiven Reflexionseigenschaften. Die Streuung der nicht-reflektierten Elektronen geschieht dann in dem weiter außenliegenden Bereich mit Streueigenschaften. Eine entsprechende magnetische Schicht mit unterschiedlichen Bereichen läßt sich verhältnismäßig leicht durch Einbringen von Fremdatomen in dem zur Streuung vorgesehenen Bereich ausbilden. Außerdem kann mit einer derartigen Ausgestaltung der Magnetschichten eine besonders hohe Signalstärke erreicht werden.

Weitere vorteilhafte Ausgestaltungen des erfindungsgemäßen Dünnschichtenaufbaus gehen aus den übrigen abhängigen Ansprüchen hervor.

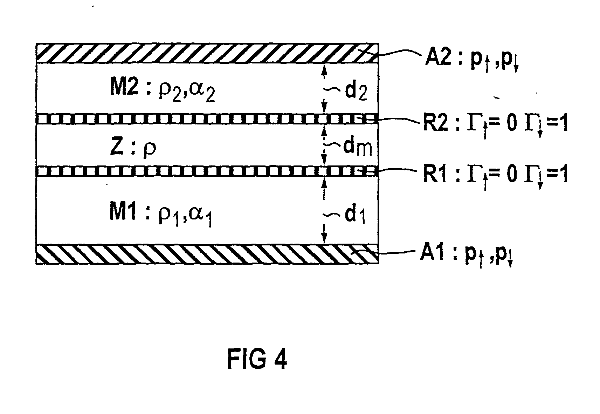

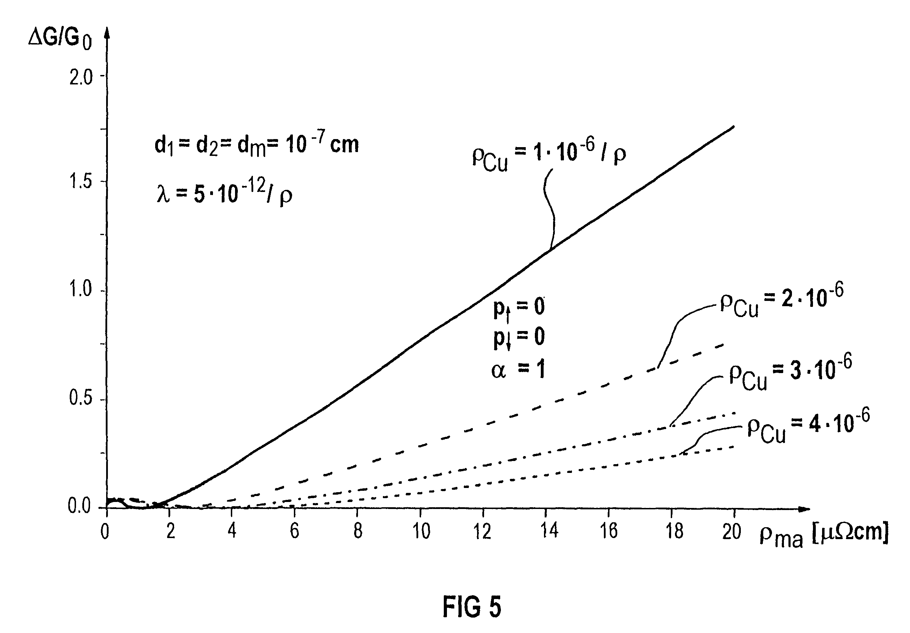

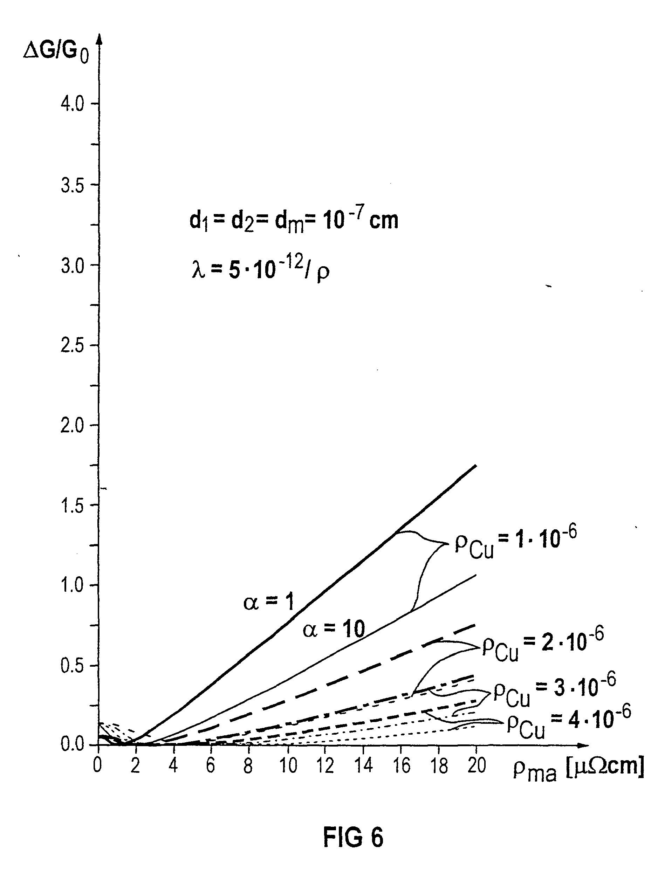

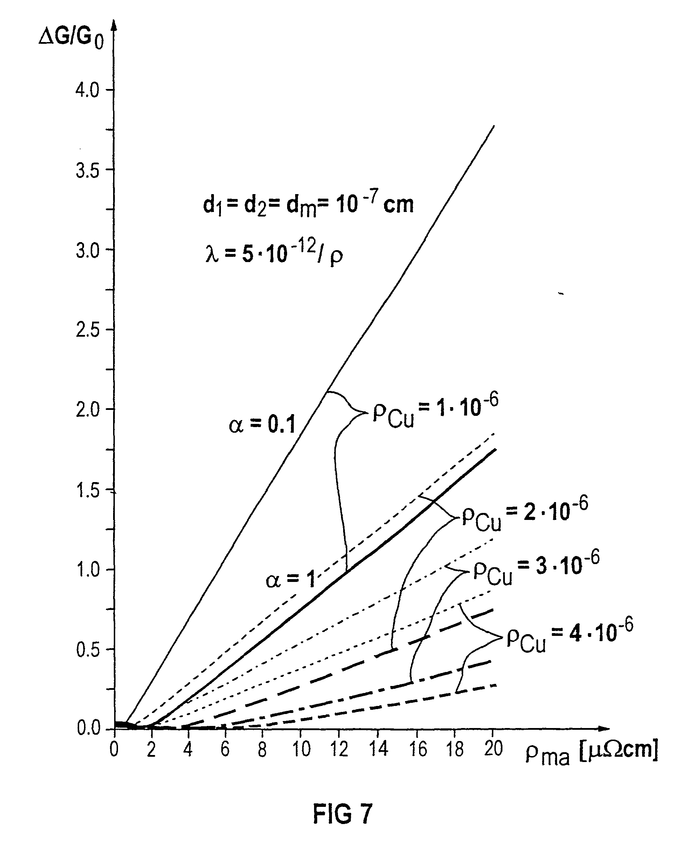

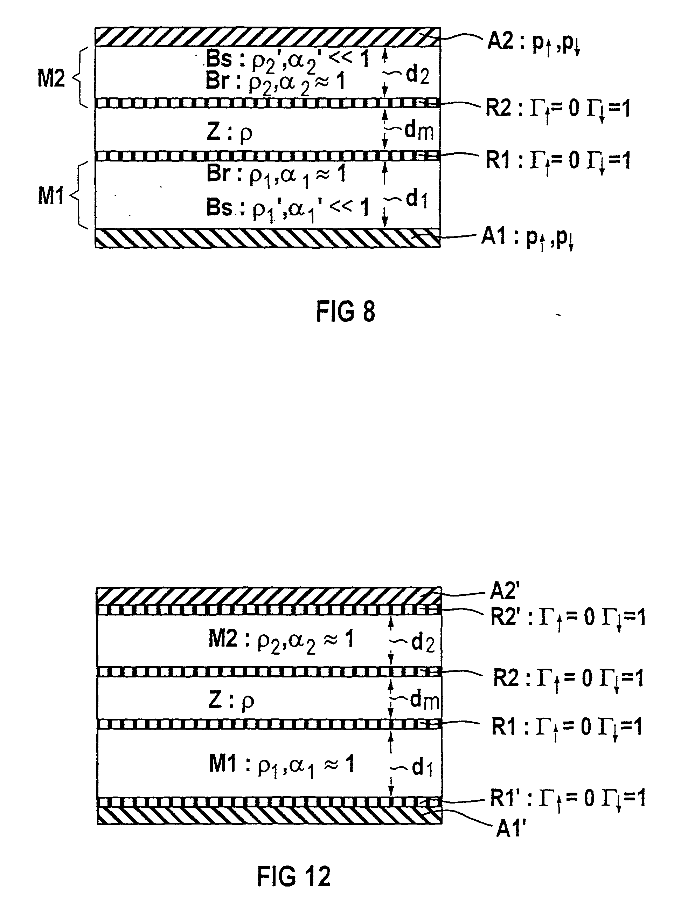

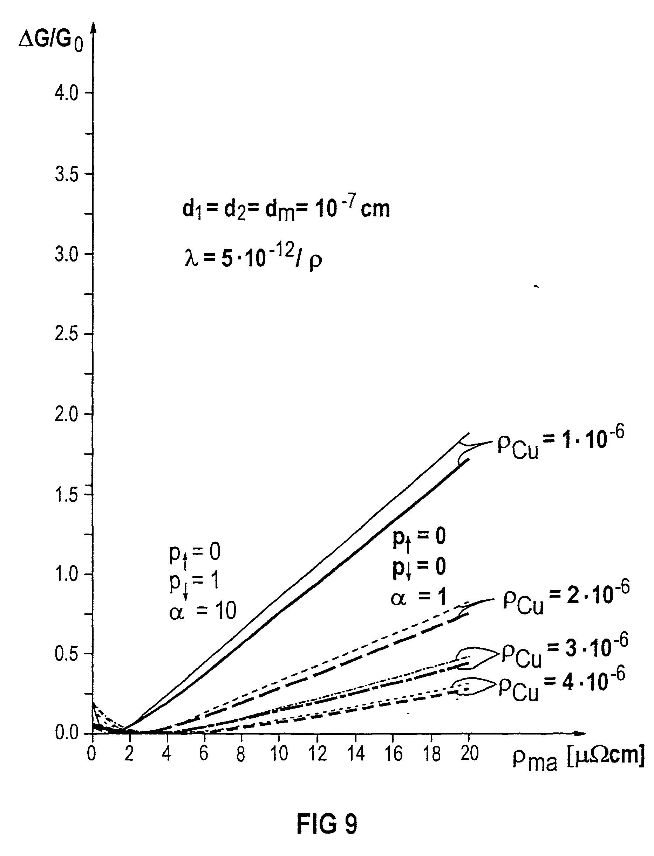

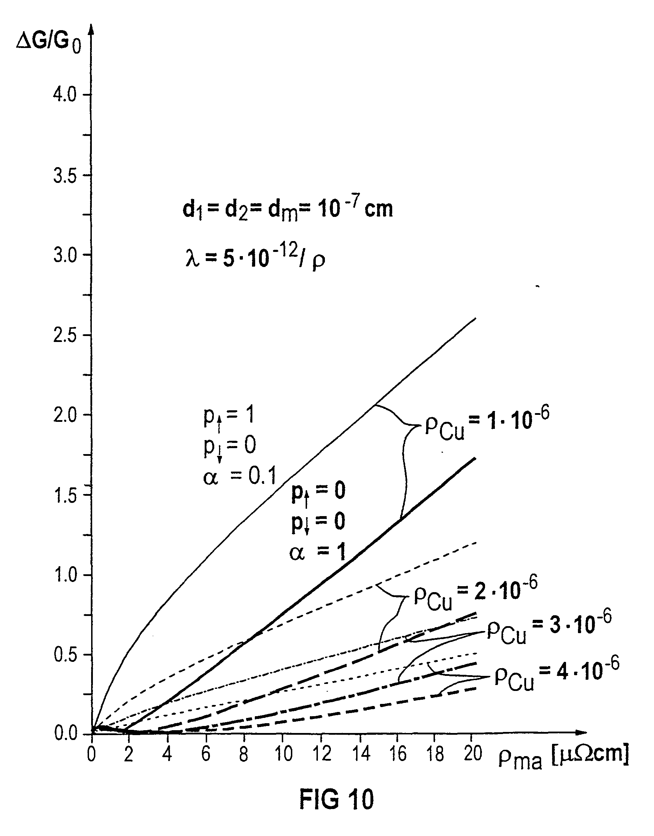

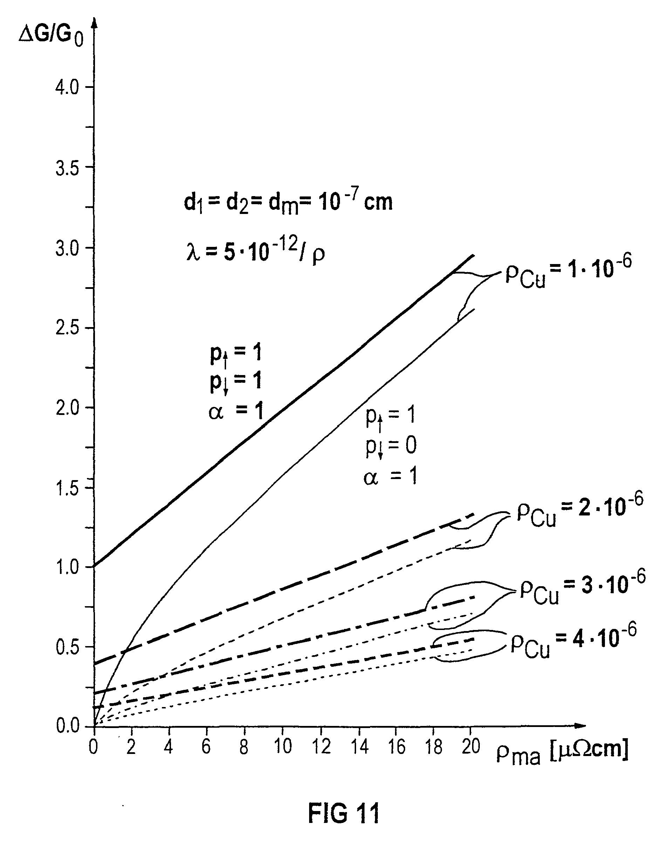

Die Erfindung wird nachfolgend anhand der Zeichnung noch weiter erläutert. Dabei zeigen jeweils schematisch
- deren Figuren: 1 bis 3 in Diagrammen Kurven der Zustandsdichte von Elektronen unterschiedlicher Spinpolarität für verschiedene Materialien,
- deren Figur 4: den prinzipiellen Aufbau eines Mehrschichtensystems nach der Erfindung mit spinreflektierenden Grenzflächen,
- deren Figur 5: in einem Diagramm den Einfluß der spinabhängigen Grenzflächenreflexion auf die relative Änderung des elektrischen Leitwertes,
- deren Figuren 6 und 7: in Diagrammen den Einfluß der spinabhängigen Volumenstreuung auf die relative Änderung des elektrischen Leitwertes,
- deren Figur 8: eine spezielle Ausführungsform eines erfindungsgemäßen Mehrschichtensystems,
- deren Figuren 9 und 10: den Einfluß der Grenzflächenreflexion auf den elektrischen Leitwert des Mehrschichtensystems nach Figur 8,
- deren Figur 11: eine weitere Ausführungsform eines erfindungsgemäßen Mehrschichtensystems
und
- deren Figur 12: den Einfluß der Grenzflächenreflexion auf dem elektrischen Leitwert des Mehrschichtensystems nach Figur 11.

In den Figuren sind sich entsprechende Teile mit denselben Bezugszeichen versehen.

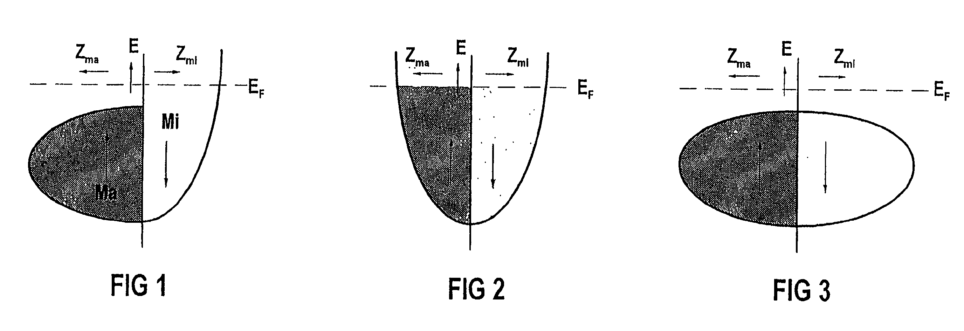

Bei den erfindungsgemäßen Maßnahmen wird von theoretischen Überlegungen ausgegangen, die in der eingangs genannten DE 196 52 536 A1 niedergelegt sind. Demgemäß ist für die Wahl des Materials für eine die Grenzfläche bildende Reflektorschicht eines Spinreflektors die Elektronenniveaudichteverteilung der d-Bänder der magnetischen Elemente zu berücksichtigen, wie sie in den Diagrammen der Figuren 1 bis 3 angedeutet ist.

Die Wahl des Materials hängt dabei davon ab, ob entweder Majoritäts- oder Minoritätselektronen reflektiert werden sollen. Im Prinzip möchte man an der Reflektorschicht die Elektronen des anderen Spintyps vollständig durchlassen. Hierbei spielt vor allem die Übereinstimmung zwischen den d-Bändern der beiden Materialien eine entscheidende Rolle. Anhand der Figuren 1 bis 3 sind die drei wesentlichsten Fälle von d-Bandstrukturen angedeutet. Dabei wurde eine bekannte Darstellung der d-Bandstrukturen in Form von Diagrammen unter Zugrundelegung bekannter Parameter gewählt (vgl. z.B. das Buch *"Handbook of the band structure of elemental solids" von D. A. Papaconstantopoulos, Plenum Press, New York u.a., 1986, insbesondere Seiten 73 bis 126*). In den Diagrammen sind jeweils in Ordinatenrichtung das Energieniveau E der Elektronen und in Abszissenrichtung die Zustandsdichten Zₘᵢ und Zₘₐ aufgetragen. Das Fermi-Niveau ist jeweils mit E_{F} bezeichnet. Figur 1 zeigt die typische asymmetrische d-Bandstruktur von den ferromagnetischen Elementen Ni und Co. Die Zustandsdichten Zₘₐ und Zₘᵢ sind dabei den Majoritätselektronen Ma bzw. den Minoritätselektronen Mi zugeordnet. Aus den Figuren 2 und 3 sind die d-Bandstrukturen der Elemente veranschaulicht, die gegenüber den ferromagnetischen Elementen Ni und Co eine kleinere Ordnungszahl im Periodensystem (Figur 2) bzw. eine größere Ordnungszahl im Periodensystem (Figur 3) aufweisen. Möchte man Minoritätselektronen Mi reflektieren, dann kämen nach Figur 3 vor allem Elemente in Frage, die rechts von dem magnetischen Element in dem periodischen System angesiedelt sind. Im Falle von Co wäre beispielsweise Cu geeignet. Bei einer gewünschten Reflexion von Majoritätselektronen Ma sind es die Elemente links vom magnetischen Element im Periodensystem, die die geeignete 3d-Bandstruktur aufweisen. Beispielsweise sind Mn, Cr oder V geeignete Reflektormaterialien. Wie aus Figur 2 hervorgeht, paßt das d-Band dieser Materialien gut zusammen mit dem Minoritätenband. In diesem Falle werden also vorwiegend Majoritätselektronen an der Grenzfläche reflektiert.

Zu einer Reflexion von Minoritätselektronen wird also zumindest für die Reflektorschicht eines Spinreflektors vorteilhaft ein Material gewählt, das wenigstens als Hauptbestandteil (zu mehr als 50 Atom-%) ein Element aus einer bestimmten Gruppe der Elemente des Periodensystems enthält, die im Periodensystem rechts von der Gruppe der ferromagnetischen Übergangsmetalle des Materials der benachbarten Magnetschicht liegt. Und zwar sind das die Elemente aus den - soweit vorhandenen - benachbarten Gruppen VIIIb der Übergangsmetalle oder aus einer der Gruppen Ib, IIb oder IIIa (gemäß der Darstellung in dem Buch *"Anorganische Chemie" von E. Riedel, Verlag W. de Gruyter, Berlin u.a., 1988, letzte Doppelseite*). Als besonders geeignet sind die Elemente Cu, Ag, Au oder Al anzusehen. Wenn z.B. Fe das ferromagnetische Material der Magnetschicht ist, kommen darüber hinaus auch noch nicht-ferromagnetische Elemente aus der Co- und Ni-Gruppe wie z.B. Rh bzw. Pd in Frage. Sollen demgegenüber Majoritätselektronen spinabhängig reflektiert werden, so wird für die Reflektorschicht vorteilhaft ein Material aus einer der Gruppen IV bis VIII der Übergangsmetalle gewählt, wobei die jeweilige Gruppe immer links von der Gruppe der benachbarten Magnetschicht liegen soll. Vorzugsweise wird eines der Elemente Mn, Cr, V oder Ti vorgesehen. Besteht die Magnetschicht z.B. aus Ni, so kommen auch noch nicht-ferromagnetische Elemente aus der Co- und Fe-Gruppe wie z.B. Rh bzw. Ru in Frage.

Welcher Elektronentyp einer Spinrichtung am stärksten an einer Grenzfläche reflektiert wird, hängt von dem nicht-magnetischen Element einer an die magnetische Schicht angrenzenden Zwischenschicht ab. Bei Cu werden hauptsächlich die Minoritätselektronen reflektiert, während es bei Cr gerade die Majoritätselektronen sind. Bei den nachfolgenden Betrachtungen wird davon ausgegangen, daß die Majoritätselektronen vollständig durchgelassen und nur die Minoritätselektronen zu 100 % reflektiert werden. Für den umgekehrten Fall gelten analoge Überlegungen. Der nachfolgend zugrundegelegte Schichtaufbau und die Definitionen der wichtigsten physikalischen Größen sind anhand des in Figur 4 gezeigten Mehrschichtensystems dargestellt. Dabei sind die folgenden Bezeichnungen gewählt, nämlich ρ für den spezifischen Widerstand, Γ für den Reflexionskoeffizienten, M1, M2 für zwei magnetische Schichten (Magnetschichten), Z für eine Zwischenschicht, A1, A2 für zwei spinabhängig absorbierende Schichten (Absorptionsschichten), p für deren Streuzentrendichte und R1, R2 für zwei spinabhängig reflektierende Grenzflächen (Reflektorflächen). Die Indizes 1 und 2 beziehen sich dabei jeweils auf die Magnetschichten M1 bzw. M2, die Indizes Pfeil ↑ und Pfeil ↓ auf Majoritätselektronen bzw. Minoritätselektronen. Ferner ist die Spinabhängigkeit, die für den GMR-Effekt charakteristisch ist, in bekannter Weise durch eine Größe α angegeben. Diese Größe ist definiert durch das Verhältnis ρ↓/ρ↑ (vgl. z.B. das Buch *"Ferromagnetic Materials", Vol. 3, Ed.: E. P. Wohlfarth, North-Holland Publ. Co.,* Am*sterdam u.a., 1982, Seiten 747 bis 804, insbesondere Seiten 758 bis 762*). Dabei sind ρ↓ und ρ↑ die spezifischen elektrischen Widerstände des Materials bezüglich Minoritäts- bzw. Majoritätselektronen. So gilt z.B. für α > 1, daß die Minoritätselektronen den höchsten spezifischen Bulkwiderstand haben.

Das in Figur 4 gezeigte, vorzugsweise mit MBE-Abscheideverfahren herzustellende Mehrschichtensystem enthält folglich zwei Magnetschichten M1 und M2 der Schichtdicke d₁ bzw. d₂, die durch eine nicht-magnetische Zwischenschicht Z der Dicke dₘ getrennt sind. Die Schichtdicken liegen dabei zumindest im Fall der Zwischenschicht Z im Nanometerbereich. Eine diffuse Streuung der Elektronen findet im Volumen dieser Schichten und an den weiter außenliegenden Grenzflächen statt. Eine eventuelle spinabhängige Streuung in den Magnetschichten wird von der Größe α = ρ↓/ρ↑ repräsentiert, wobei an den äußeren Grenzflächen die diffusen Streukoeffizienten (Streuzentrendichten) p↓ und p↑ für die Minoritäts- bzw. Majoritätselektronen gelten. Wenn ein Elektron an der äußeren Grenzfläche nicht diffus gestreut wird (mit p↓,↑ = 0), wird es reflektiert.

Auch wenn keine Spinabhängigkeit der Streuung vorliegt, ergibt sich ein magnetoresistives Signal für zwei gleiche Magnetschichten, wie aus dem Diagramm der Figur 5 hervorgeht. In dem Diagramm sind in Abszissenrichtung der spezifische Widerstand ρₘₐ (für die Majoritätselektronen) und in Ordinatenrichtung die relative Änderung ΔG/G₀ des elektrischen Leitwertes eines Mehrschichtensystems gemäß Figur 4 aufgetragen. Dabei wurde für das Mehrschichtensystem angenommen, daß die Dicken d₁, d₂, dₘ der Magnetschichten M1, M2 und der Zwischenschicht Z gleich sind und 10⁻⁷ cm betragen. Für die freie Weglänge λ wurde 5 · 10⁻¹²/ρ veranschlagt. Darüber hinaus wurde eine spinabhängige Reflexion an den aus Darstellungsgründen übermäßig stark eingezeichneten Grenzflächen R1, R2 vorausgesetzt. Die einzelnen Kurven des Diagramms ergeben sich für unterschiedliche Leitfähigkeiten des Zwischenschichtmaterials, für das im vorliegenden Fall Cu gewählt wurde. Dabei kann die jeweilige Größe von ρ durch die Sauberkeit des Materials bezüglich Fremdatomen und durch die Kristallitgröße eingestellt werden. So ergibt sich z.B. für größere Kristallite des Materials der angegebene Wert von 2 · 10⁻⁶, für kleinere Kristallite der Wert von 3 · 10⁻⁶ und für verhältnismäßig verunreinigtes Material der Wert von 4 · 10⁻⁶. Wie aus dem Diagramm hervorgeht, gibt es nur ein Signal ΔG/G₀ (mit G₀ = Leitwert bei entgegengesetzt gerichteten Magnetisierungen der Magnetschichten M1 und M2), wenn die spezifischen Widerstände der Magnetschichten und der Zwischenschicht unterschiedlich sind. Das Signal wird groß, falls der Quotient ρₘₐ/ρ groß ist. Ferner ist das Signal am größten bei niedrigem ρ-Wert der Zwischenschicht Z.

Ein erfindungsgemäßes Mehrschichtensystem sieht deshalb folgende Merkmale vor:
a) Die Zwischenschicht Z besteht aus einem Material mit einem möglichst geringen (elektrischen) ρ-Wert. Geeignete Materialien sind deshalb Au, Cu, Ag. Cr ist in diesem Fall weniger geeignet.
b) Die Magnetschichten M1 und M2 bestehen aus Materialien mit einem vergleichsweise größeren, vorzugsweise möglichst hohen (elektrischen) ρ-Wert. Solche Werte lassen sich insbesondere durch Zulegieren von Fremdatomen zu den magnetischen Elementen Fe, Co, Ni erreichen.
c) Die Grenzflächen R1, R2 der Zwischenschicht Z mit den benachbarten Magnetschichten M1, M2 weisen einen möglichst hohen Unterschied der Reflexion für beiden Spinrichtungen auf. Es werden Materialien mit möglichst guter Anpassung der Gitterabmessungen, d.h. möglichst geringem Gitter- "Missmatch" vorgesehen. Gemäß der Erfindung wird diese Bedingung bei einem Missmatch von unter 3 % gewährleistet. Ferner sind die Materialkombinationen für die Magnet- und Zwischenschichten unter dem Gesichtspunkt auszuwählen, daß sie sich insbesondere bei den Abscheide- und Strukturierungsbedingungen dieser Schichten nicht mischen (sogenannte Material-Segregation).

Im allgemeinen wird bei einem Zulegieren von Fremdatomen zu den Materialien der Magnetschichten die Größe α stark beeinflußt. So wird z.B. für ein ferromagnetisches Material (wie Fe) durch Zulegieren eines Elementes, das im Periodensystem weiter rechts von dem ferromagnetischen Material steht (wie in diesem Falle z.B. das Cu) ein Wert von α erhalten, der größer 1 ist. Wird umgekehrt ein Element dem ferromagnetischen Material (wie Fe) hinzulegiert, das im Periodensystem weiter links von diesem steht (wie z.B. Mn), dann liegt der Wert von α unter 1. Aus den Diagrammen der Figuren 6 und 7 ist der entsprechende Einfluß der spinabhängigen Streuung im Volumen der Magnetschichten auf den relativen elektrischen Leitwert ersichtlich. Für diese Diagramme wurde eine Darstellung entsprechend Figur 5 gewählt. Die Kurven der Diagramme unterscheiden sich durch die ihnen zugrundegelegte Größe α. Aus Vergleichsgründen wurde in beiden Diagrammen die Referenzkurve für α = 1 fett dargestellt. Ferner wurde für alle Größen α angenommen, daß 1/ρₘₐ = 1/ρ↑ + 1/ρ↓ ist. Aus einem Vergleich der Kurven in beiden Diagrammen ist ersichtlich, daß der größte Effekt bei gegebener spinabhängiger Reflexion, bei der Minoritätselektronen reflektiert werden und die Majoritätselektronen ungehindert durchgehen, bei Werten der Größe α < 1 auftritt (siehe Figur 7). Es ist deshalb besonders vorteilhaft, wenn für ein Mehrschichtensystem eines erfindungsgemäßen Dünnschichtenaufbaus zusätzlich zu den vorgenannten Maßnahmen noch folgende Maßnahmen ergriffen werden:
a) Sollen Minoritätselektronen an den Grenzflächen der Zwischenschicht bevorzugt reflektiert werden wie z.B. im Falle von Fe/Au oder Fe/Ag oder Co/Cu, dann werden den Magnetschichten Elemente beigemischt, deren Größe α < 1 ist.
b) Sollen hingegen Majoritätselektronen an den Grenzflächen der Zwischenschicht bevorzugt reflektiert werden wie im Falle von Fe/Cr, Fe/V, Co/Cr, dann werden den Magnetschichten Elemente beigemischt, deren α-Werte größer 1 sind.

In diesem Zusammenhang ist zu bedenken, daß eine Grenzflächenstreuung eine gerade entgegengesetzte Tendenz aufweist. Im Falle einer Reflexion von Minoritätselektronen ist die Elektronenenergieniveaudichte am Fermi-Niveau am größten, was zu einem α-Wert von größer 1 führt. Dies bedeutet, daß die Grenzflächen genügend perfekt sein müssen. Dies ist durch die erfindungsgemäße Gitteranpassung und die Nicht-Mischbarkeit gewährleistet. Generell ist jedoch die letztere Anforderung für legierte Magnetschichten schwieriger zu erfüllen. Es bietet sich dann ein aus der Figur 8 entnehmbarer Aufbau an. Bei diesem Aufbau wird von dem in Figur 4 gezeigten Mehrschichtensystem ausgegangen. Gegenüber dessen Aufbau unterscheidet sich der in Figur 8 gezeigte Aufbau des Mehrschichtensystems darin, daß dessen Magnetschichten M1 und M2 in jeweils mindestens zwei schichtartigen Bereiche Bs und Br unterteilt sind. Mit Bs ist der in der Figur grau dargestellte Bereich zur Streuung von Minoritätselektronen und Br der in der Figur hell dargestellte Bereich zur Reflexion der Elektronen dieses Spintyps bezeichnet. Angrenzend an die Zwischenschicht Z befindet sich jeweils der Bereich Br mit optimalen Reflexionseigenschaften und demgegenüber weiter außenliegend jeweils der mindestens eine, grau dargestellte Bereich Bs mit optimalem Streuverhalten. Die Streuwirkung des Bereichs Bs läßt sich in an sich bekannter Weise durch Zumischen von Fremdatomen zum Material, d.h. durch entsprechenden Einbau von Streuzentren erreichen. Daß eine derartige Trennung der Funktionen "Reflexion" und "Streuung" tatsächlich möglich ist, läßt sich anhand der Diagramme der Figuren 9 und 10 erkennen, für die eine Darstellung gemäß den Figuren 6 und 7 gewählt ist. Die Größe α der Magnetschichten M1 und M2 ist dabei mit 1 gewählt worden. Bei den entsprechenden, fett eingezeichneten Kurven, bei denen die Streuung an den Grenzflächen R1 und R2 praktisch null ist, ist dann ΔG/G₀ null, wenn ρₘₐ = ρ_{cu} der Zwischenschicht Z ist. Das Diagramm der Figur 9 zeigt die Situation, wenn die Minoritätselektronen stark streuen, während die Majoritätselektronen vollständig reflektiert werden. Das bedeutet aber, daß der effektive Wert von α der Magnetschichten M1 und M2 größer 1 wird, also eine weniger erwünschte Art einer spinabhängigen Streuung, wie vorstehend dargelegt, auftritt. Ein kleiner Anstieg des Signals ist trotzdem zu erkennen wegen der Zunahme des effektiven Wertes von ρₘₐ. Es ist deswegen davon auszugehen, daß bei einer stark spinunabhängigen Streuung ein noch größerer Signalgewinn zu erreichen ist. Eine Bestätigung hierfür ist dem Diagramm der Figur 11 zu entnehmen, für eine den Figuren 9 und 10 entsprechende Darstellung gewählt wurde.

Wie aus dem Diagramm der Figur 10 abzulesen ist, wird ein deutlich größeres Signal erreicht, wenn bevorzugt Majoritätselektronen an der Grenzfläche R1 bzw. R2 gestreut werden. Der relative Gewinn ist besonders hoch, wenn ρₘₐ ungefähr gleich ρ_{cu} ist. Aus diesen Erkenntnissen für eine spinabhängige Reflexion und Streuung lassen sich die folgenden Maßnahmen ableiten. Hierbei wird auf das in Figur 12 dargestellte Mehrschichtensystem Bezug genommen. Dieses Mehrschichtensystem unterscheidet sich von dem System gemäß Figur 8 dadurch, daß an seinen Außenseiten jeweils eine Kombination einer Absorptionsschicht A1' bzw. A2' und eine der jeweiligen Magnetschicht zugewandte spinselektive Reflektorgrenzschicht oder - fläche R1' bzw. R2' vorhanden sind. Für das Mehrschichtensystem nach Figur 12 sind dann vorteilhaft folgende Maßnahmen vorzusehen:
1) Wenn an den Grenzflächen R1 und R2 zu der Zwischenschicht Z die Majoritätselektronen vorwiegend durchgelassen und die Minoritätselektronen reflektiert werden, wie dies z.B. für das System Co/Cu der Fall ist, dann müssen die spinabhängigen Reflektoren an den äußeren Grenzflächen R1' und R2' die Majoritätselektronen der benachbarten Magnetschichten M1 bzw. M2 streuen und die Minoritätselektronen reflektieren. Dies ist z.B. durch eine weitere Cu-Schicht zu erreichen.
2) Wenn an den Grenzflächen R1 und R2 zu der Zwischenschicht Z die Minoritätselektronen vorwiegend durchgelassen und die Majoritätselektronen reflektiert werden sollen, wie dies z.B. für das System Fe/Cr der Fall ist, dann müssen die spinabhängigen Reflektoren an den äußeren Grenzflächen R1' und R2' die Majoritätselektronen der benachbarten Magnetschichten M1 bzw. M2 streuen und die Minoritätselektronen reflektieren. Dies wäre z.B. durch eine weitere Cr-Schicht als spinselektiver Reflektor R1' bzw. R2' zu erreichen.

Zur erwünschten Trennung der beiden Funktionen darf jedoch die jeweilige Absorptionsschicht A1' bzw. A2' nicht spinabhängig streuen. Sie sollte deshalb eine hohe Resistivität aufweisen, wie sie z.B. durch Legierungen zu erreichen ist. Wenn jedoch diese Absorptionsschichten spinabhängig streuen sollten, dann sollten bevorzugt Majoritätselektronen gestreut werden.

Aus diesen vorgenannten Überlegungen lassen sich die folgenden Maßnahmen ableiten:
1) Der Spinreflektor R1' bzw. R2' an der Außenseite sollte Elektronen vom gleichen Spintyp bevorzugt reflektieren wie der durch die Grenzfläche R1 bzw. R2 erzeugte Spinreflektor an der Zwischenschicht Z.
2) Die zusätzliche Absorptionsschicht A1' bzw. A2' sollte eine möglichst hohe Resistivität besitzen und nicht reflektieren.
3) Wenn die Absorptionsschicht spinselektiv streuen sollte, so sollte sie bevorzugt die von dem Spinreflektor spinselektiv durchgelassenen Elektronen vom jeweiligen Spintyp streuen.
4) Um einer Reflexion der jeweiligen Absorptionsschicht A1' bzw. A2' vorzubeugen, kann man vorzugsweise diese Schicht so ausbilden, daß ihre Streuzentrendichte von ihrem zugeordneten Spinreflektor R1' bzw. R2' aus in Richtung nach außen hin zunimmt. Dies läßt sich z.B. durch Hinzulegieren einer Legierungskomponente mit in dieser Richtung zunehmendem Anteil erreichen.

Gemäß einem konkreten Ausführungsbeispiel eines Mehrschichtenaufbaus nach Figur 4 ist der folgende Aufbau vorgesehen:
Zwischenschicht Z: Ag, dₘ = 10⁻⁷ cm
Magnetschichten M1, M2: d₁ = d₂ = 10⁻⁷ cm; Br: Fe,
Dicke = 5 · 10⁻⁸ cm, Bs: FeZr; Dicke = 5 · 10⁻⁸ cm
Absorptionsschichten A1, A2: Cu, Dicke etwa 10⁻⁶ cm (unkritisch)
magnetoresistiver Effekt Mᵣ = [R(0) - R(B)]/R(0) mit R(0) = ohmscher Widerstand ohne Magnetfeld und R(B) = ohmscher Widerstand bei magnetischer Induktion B: etwa 10 % (bei Raumtemperatur).

Bei den vorstehenden Ausführungsbeispielen wurde davon ausgegangen, daß die Magnetschichten M1 und M2 aus dem gleichen Material bestehen und die gleiche Dicke d1 = d2 aufweisen. Die erfindungsgemäßen Maßnahmen sind jedoch nicht auf derartige Mehrschichtensysteme beschränkt. Sie sind ebensogut auch für Mehrschichtensysteme geeignet, deren Magnetschichten unterschiedliche magnetische Härte (bzw. Koerzitivfeldstärke) besitzen. So kann insbesondere ein Mehrschichtensystem mit einer weichmagnetischen Meßschicht und einem vergleichsweise härteren Biasschichtteil vorgesehen sein. Dieser Biasschichtteil kann aus einer einzigen Schicht oder einer Schichtenfolge bestehen, die insbesondere als sogenannter künstlicher, Antiferromagnet ausgebildet sein kann (vgl. die genannte DE 196 52 536 A1).

## Patentansprüche

1. Dünnschichtenaufbau eines magnetfeldempfindlichen Sensors mit einem Mehrschichtensystem, das einen erhöhten magnetoresistiven Effekt sowie eine Spinabhängigkeit der Elektronenstreuung von Majoritäts- und Minoritätselektronen zeigt und das mindestens eine die Elektronen in Abhängigkeit von ihrem Spin reflektierende Grenzfläche zwischen benachbarten Schichten sowie Bereiche enthält, in denen eine zumindest weitgehend diffuse Streuung von nicht-reflektierten Elektronen erfolgt, wobei die mindestens eine spinabhängig reflektierende Grenzfläche (R1, R2; R1', R2') zwischen benachbarten Schichten (M1, Z bzw. M2, Z) aus einem magnetischen bzw. nicht-magnetischen Material liegt, wobei die Materialien aneinander angepaßte Gitterabmessungen mit Abweichungen von höchstens 3 % aufweisen und unter den Herstellungsbedingungen dieser Schichten nicht-mischbar sind, **dadurch gekennzeichnet, daß** an der der Zwischenschicht (Z) abgewandten Außenseite wenigstens einer der magnetischen Schichten (M1, M2) eine Absorptionsschicht (A1, A2) zur Streuung von nicht-reflektierten Elektronen vorgesehen ist.

2. Aufbau nach Anspruch 1, **gekennzeichnet durch** eine Zwischenschicht (Z) aus einem Material mit geringem spezifischen elektrischen Widerstand und **durch** dazu benachbarte magnetische Schichten (M1, M2) aus mindestens einem Material mit vergleichsweise größerem spezifischen elektrischen Widerstand.

3. Aufbau nach Anspruch 2, **gekennzeichnet durch** magnetische Schichten (M1, M2), deren mindestens ein Material einen **durch** Zulegieren erhöhten spezifischen elektrischen Widerstand aufweist.

4. Aufbau nach einem der vorangehenden Ansprüche, **gekennzeichnet durch** ein nicht-magnetisches Material der Zwischenschicht (Z) aus der Gruppe der Elemente Au, Cu, Ag.

5. Aufbau nach einem der vorangehenden Ansprüche, **gekennzeichnet durch** ein magnetisches Material der magnetischen Schichten aus der Gruppe der Elemente Fe, Co, Ni und deren Legierungen.

6. Aufbau nach einem der vorangehenden Ansprüche, **dadurch gekennzeichnet, daß** die Zwischenschicht (Z) zumindest in Form von inselartigen Teilbereichen aus dem nicht-magnetischen Material ausgebildet ist, wobei die Teilbereiche jeweils eine Mindestfläche einnehmen, die einer kreisförmigen Fläche mit einem Durchmesser entspricht, der mindestens das 3-Fache, vorzugsweise mindestens das 4-Fache der Atomabstände des nicht-magnetischen Materials oder des magnetischen Materials der jeweils benachbarten magnetischen Schicht (M1 bzw. M2) beträgt.

7. Aufbau nach Anspruch 1, **dadurch gekennzeichnet, daß** die Außenschicht (A1, A2) spinselektiv streuend ist.

8. Aufbau nach Anspruch 1 oder 7, **dadurch gekennzeichnet, daß** zwischen der Absorptionsschicht (A1, A2) und der zugeordneten magnetischen Schicht (M1 bzw. M2) eine spinselektive Grenzfläche (R1', R2') ausgebildet ist.

9. Aufbau nach einem der vorangehenden Ansprüche, **dadurch gekennzeichnet, daß** zumindest eine der magnetischen Schichten (M1, M2) einen der Zwischenschicht (Z) zugewandten schichtartigen Bereich (Br) mit spinselektiven Reflexionseigenschaften und einen demgegenüber weiter außenliegenden schichtartigen Bereich (Bs) mit Streueigenschaften aufweist.

10. Aufbau nach einem der vorangehenden Ansprüche, **dadurch gekennzeichnet, daß** die magnetischen Schichten (M1, M2) unterschiedliche magnetische Härte haben.

11. Aufbau nach Anspruch 10, **dadurch gekennzeichnet, daß** die magnetisch härtere Schicht als ein Biasschichtteil ausgebildet ist.

12. Aufbau nach Anspruch 11, **dadurch gekennzeichnet, daß** der Biasschichtteil eine einen künstlichen Antiferromagneten bildende Schichtenfolge ist.

## Claims

1. Thin-film structure of a magnetic field sensor having a multilayer system, which exhibits an enhanced magnetoresistive effect as well as a spin dependency of the electron scattering of majority and minority electrons and contains at least one interface between neighboring layers which reflects the electrons as a function of their spin and regions in which at least substantially diffuse scattering of unreflected electrons takes place, the at least one interface (R1, R2; R1', R2') which reflects as a function of spin lying between neighboring layers (M1, Z or M2, Z) of a magnetic and nonmagnetic material, respectively, the materials having lattice dimensions matched to one another with deviations of at most 3% and being immiscible under the production conditions of these layers, **characterized in that** an absorption layer (A1, A2) for scattering unreflected electrons is provided on the outer side, remote from the interlayer (Z), of at least one of the magnetic layers (M1, M2).

2. Structure according to Claim 1, **characterized by** an interlayer (Z) of a material with low electrical resistivity and by magnetic layers (M1, M2), neighboring it, of at least one material with comparatively higher electrical resistivity.

3. Structure according to Claim 2, **characterized by** magnetic layers (M1, M2) of which at least one material has an electrical resistivity enhanced by alloying.

4. Structure according to one of the preceding claims, **characterized by** a nonmagnetic material of the interlayer (Z) from the group of elements Au, Cu, Ag.

5. Structure according to one of the preceding claims, **characterized by** a magnetic material of the magnetic layers from the group of elements Fe, Co, Ni and their alloys.

6. Structure according to one of the preceding claims, **characterized in that** the interlayer (Z) is designed at least in the form of island-like subregions of the nonmagnetic material, the subregions each taking up a minimum area which corresponds to a circular area with a diameter which is at least three times, preferably four times, the atomic spacings of the nonmagnetic material or the magnetic material of the respective neighboring magnetic layer (M1 or M2).

7. Structure according to Claim 1, **characterized in that** the outer layer (A1, A2) scatters spin-selectively.

8. Structure according to Claim 1 or 7, **characterized in that** a spin-selective interface (R1', R2') is formed between the absorption layer (A1, A2) and the associated magnetic layer (M1 or M2).

9. Structure according to one of the preceding claims, **characterized in that** at least one of the magnetic layers (M1, M2) has a layer-like region (Br) facing the interlayer (Z), with spin-selective reflection properties and a layer-like region (Bs), lying further out therefrom, with scattering properties.

10. Structure according to one of the preceding claims, **characterized in that** the magnetic layers (M1, M2) have different magnetic hardnesses.

11. Structure according to Claim 10, **characterized in that** the magnetically harder layer is formed as a bias layer part.

12. Structure according to Claim 11, **characterized in that** the bias layer part is a layer sequence forming an artificial antiferromagnetic.

## Revendications

1. Structure à couche mince d'un capteur sensible au champ magnétique ayant un système multicouche, qui a un effet magnétorésistif accru ainsi qu'une diffusion électronique, dépendante du spin magnétique, des électrons majoritaires et des électrons minoritaires, et qui a au moins une surface limite, réfléchissant les électrons en fonction de leur spin, entre des couches voisines, ainsi que des zones dans lesquelles se produit une dispersion au moins largement diffuse d'électrons non réfléchis, la au moins une surface limite (R1, R2 ; R1', R2') réfléchissant en fonction du spin étant située entre des couches voisines (M1, Z ou M2, Z) en matériau magnétique ou amagnétique, les matériaux présentant des dimensions de réseau adaptées les unes aux autres, avec des divergences de 3 % au plus, et n'étant pas miscibles dans les conditions de fabrication de ces couches, **caractérisée en ce que**, sur le côté extérieur, éloigné de la couche intermédiaire (Z), d'au moins une des couches magnétiques (M1, M2), il est prévu une couche d'absorption (A1, A2) pour la dispersion d'électrons non réfléchis.

2. Structure selon la revendication 1, **caractérisée par** une couche intermédiaire (Z) dans un matériau ayant une résistance électrique spécifique petite, et par des couches magnétiques (M1, M2) qui lui sont voisines, dans au moins un matériau ayant une résistance électrique spécifique comparativement plus grande.

3. Structure selon la revendication 2, **caractérisée par** des couches magnétiques (M1, M2) dont au moins un matériau présente une résistance électrique spécifique accrue par alliage.

4. Structure selon une des revendications précédentes, **caractérisée par** un matériau amagnétique de la couche intermédiaire (Z) issu du groupe des éléments Au, Cu, Ag.

5. Structure selon une des revendications précédentes, **caractérisée par** un matériau magnétique des couches magnétiques issu du groupe des éléments Fe, Co, Ni et de leurs alliages.

6. Structure selon une des revendications précédentes, **caractérisée en ce que** la couche intermédiaire (Z) est constituée au moins sous forme de zones partielles de type îlot réalisées dans le matériau amagnétique, les zones partielles occupant respectivement une surface minimale qui correspond à une surface circulaire ayant un diamètre qui représente au moins le triple, de préférence au moins le quadruple, des distances interatomiques du matériau amagnétique ou du matériau magnétique de la couche magnétique (M1 ou M2) respectivement voisine.

7. Structure selon la revendication 1, **caractérisée en ce que** la couche extérieure (A1, A2) est dispersante de façon sélective du point de vue du spin.

8. Structure selon la revendication 1 ou 7, **caractérisée en ce que**, entre la couche d'absorption (A1, A2) et la couche magnétique (M1 ou M2) affectée, une surface limite (R1', R2'), sélective du point de vue du spin, est constituée.

9. Structure selon une des revendications précédentes, **caractérisée en ce qu'**au moins une des couches magnétiques (M1, M2) présente une zone (Br), de type couche, tournée vers la couche intermédiaire (Z), ayant des caractéristiques de réflexion sélectives du point de vue du spin, et une zone (Bs), de type couche, située en revanche plus à l'extérieur, ayant des caractéristiques de dispersion.

10. Structure selon une des revendications précédentes, **caractérisée en ce que** les couches magnétiques (M1, M2) ont une dureté magnétique différente.

11. Structure selon la revendication 10, **caractérisée en ce que** la couche plus dure magnétiquement est constituée en tant que partie de couche de polarisation.

12. Structure selon la revendication 11, **caractérisée en ce que** la partie de couche de polarisation est une suite de couches formant une substance antiferromagnétique artificielle.
